Europäisches Patentamt

European Patent Office

Office européen des brevets

(19)

(11) Publication number: **0 257 737**

**A2**

(12) **EUROPEAN PATENT APPLICATION**

(21) Application number: 87305039.7

(22) Date of filing: 08.06.87

(51) Int. Cl.⁴: **H05K 3/38** , H05K 3/10

The title of the invention has been amended (Guidelines for Examination in the EPO, A-III, 7.3).

(30) Priority: 09.06.86 US 871843

(43) Date of publication of application:
**02.03.88 Bulletin 88/09**

(84) Designated Contracting States:
**BE DE ES FR GB IT NL**

(71) Applicant: **MINNESOTA MINING AND MANUFACTURING COMPANY**
**3M Center, P.O. Box 33427**
**St. Paul, Minnesota 55133-3427(US)**

(72) Inventor: **Barjesteh, Hamid c/o Minnesota Mining and**
**Manufacturing Company 2501 Hudson Road**
**P.O. Box 33427 St. Paul Minnesota 55133(US)**

(74) Representative: **Baillie, Iain Cameron et al**
**c/o Ladas & Parry Isartorplatz 5**
**D-8000 München 2(DE)**

(54) **Printed circuit precursor.**

(57) This invention relates to presensitized circuit material.

Currently, the inner layers of multilayer printed circuit boards and flexible printed circuits are manufactured by subtractive etching of large sheets of photoresist-imaged copper clad laminate. This process is costly because of copper waste and problems relating to environmental pollution. Moreover, the circuits resulting from the process are limited by the properties of the laminate and the imaging materials used. Thus, there is a desire in the electronics industry to employ additive electroplating processes whenever possible.

This invention provides an article suitable as a presensitized circuit material comprising

(1) an electrically insulative support,

(2) a thin adhesion layer made of a conductive metal overlying said support,

(3) a thin metallic plating layer overlying said adhesion layer, and

(4) a photoresist layer overlying said plating layer. The preferred metal for the adhesion layer is an alloy of chromium and chromium oxide, i.e., black-chromium. The adhesion layer helps to provide an electrical circuit which tenaciously adheres to the electrically insulative support. This article is particularly useful in additive electroplating processes.

EP 0 257 737 A2

## PRESENSITIZED CIRCUIT MATERIAL

### BACKGROUND OF THE INVENTION

This invention relates to circuit material, and, in particular, presensitized circuit material.

Photoresist compositions and their uses are well known to those skilled in the art. For example, a photoresist composition can be applied as a coating to a substrate. This coating can then be imagewise exposed to actinic radiation, and depending on whether the photoresist composition is chosen to be positive-acting or negative-acting, the coating can be selectively removed in either the irradiated or the non-irradiated areas, respectively.

Photoresist compositions have been used extensively in forming electrical circuits. For example, an electrically insulative support can be provided with a surface layer of an electrically conductive metal by means of coating or laminating. A photoresist layer can then be applied over the electrically conductive surface layer, imagewise exposed, and then selectively removed, i.e. developed, to define the desired electrical circuit pattern. Either an additive or a subtractive process can then be used to form the actual circuit. In the subtractive process, the portion of the electrically conductive layer that is not protected by the photoresist layer after development is etched away. The portion of the electrically conductive layer lying beneath the remaining pattern-forming portion of the photoresist layer then forms the conductive elements of the electrical circuit. In the additive process, the portion of the electrically conductive layer exposed by removal of the photoresist layer is further cleaned, as by etching, and metal is plated onto that portion. Typically, the plated metal is chosen to be etch-resistant or is plated to a much greater thickness than the electrically conductive layer initially present. After plating and removal of the remaining photoresist, etchants are used to remove the remaining portion of the electrically conductive layer. The conductive elements of the electrical circuit are formed primarily by the plated metal and, to a lesser extent, by the remnant of the electrically conductive layer present beneath the plated metal.

Currently, the inner layers of multilayer printed circuit boards and flexible printed circuits are manufactured by subtractive etching of large sheets of photoresist-imaged copper clad laminate. This process is costly because of copper waste and problems relating to environmental pollution. Moreover, the circuits resulting from the process are limited by the properties of the laminate and the imaging materials used. Thus, there is a desire in the electronics industry to employ additive electroplating processes whenever possible.

Verstraete et al, U.S. Patent No. 3,832,176 describes a printed circuit precursor material. However, the printed circuit precursor described therein has been found to be unsatisfactory because of poor adhesion of the deposited circuitry to the polymeric support film and the limitations of negative-acting photoresist systems. It would be desirable to provide a better means for promoting adhesion between the support film and the deposited circuitry. Additionally, it would be desirable to employ a positive-acting photoresist because they have the following advantages over negative-acting photoresists: higher resolution capability, capability of complete removal, and capability of multiple exposures.

### SUMMARY OF THE INVENTION

In one aspect, this invention involves an article of manufacture comprising: (1) an electrically insulative support, (2) overlying and adhered to said support a thin adhesion layer made of a conductive metal, namely, an alloy of chromium and chromium oxide, (3) overlying and adhered to said adhesion layer, a thin metallic plating layer, and (4) overlying and coated onto said plating layer, a photoresist layer which permits substantially microresidue-free removal thereof from said plating layer in exposed areas while protecting the plating layer in the unexposed areas. The photoresist image then facilitates the fabrication of the conductive circuit elements by allowing a metal layer to be selectively deposited where the resist has been removed.

The preferred material for the electrically insulative support is polyimide film. The strength of the bond between the electrically insulative support and adhesion layer should be sufficient to withstand the mechanical stresses that will be placed on the circuit during the fabrication process and during the use of the circuit. An essential requirement of the adhesion layer is that it not be significantly removed by normal precleaning processes prior to electroplating. The preferred material for the plating layer is copper. The photoresist layer is preferably positive-acting, although negative-acting photoresist layers can also be used.

## BRIEF DESCRIPTION OF THE DRAWINGS

The invention may be better understood by reference to the following detailed description considered in conjunction with the drawing in which:

Figure 1 represents an article according to the present invention;

Figure 2 represents the article of Figure 1 after exposure and development of the photoresist layer;

Figure 3 represents the article of Figure 2 after plating;

Figure 4 represents the article of Figure 3 after removal of the remaining portion of the photoresist layer;

Figure 5 represents the article of Figure 4 after etching to remove the unprotected portions of the plating layer.

All figures are detailed sectional views.

## DETAILED DESCRIPTION

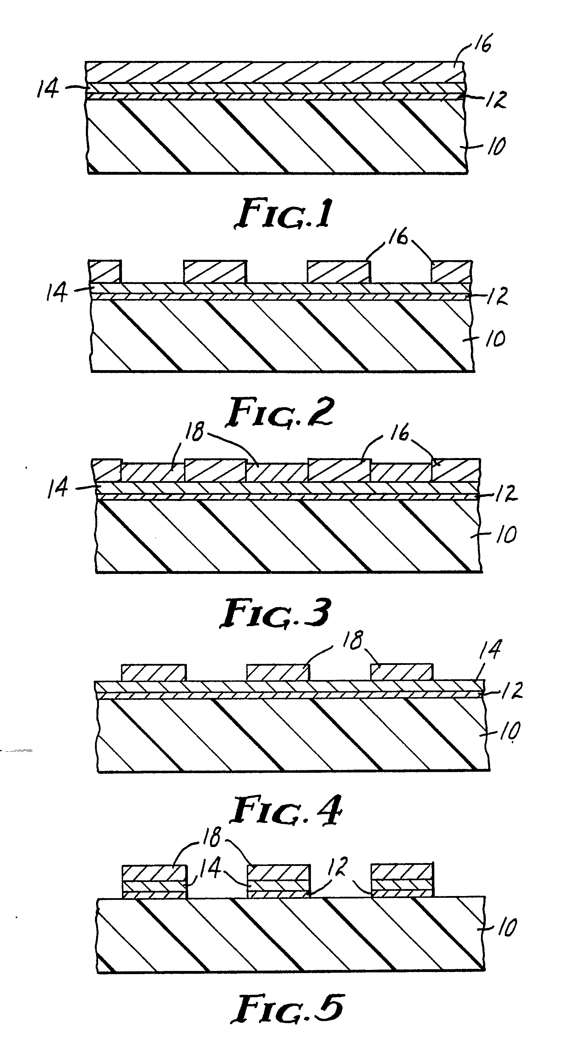

An embodiment of the article of this invention, shown in Figure 1, comprises an electrically insulative support 10, an adhesion layer 12 of a conductive metal, a thin metallic plating layer 14, and a photoresist layer 16.

Any conventional electrically insulative support 10 can be used in the practice of this invention. Those supports which are considered to be insulative within the purview of this invention are those which exhibit, at least adjacent the adhesion layer, a surface resistivity in excess of $10^8$ ohms per square and, preferably, at least $10^{12}$ ohms per square. As is well understood by those skilled in the art, surface resistivity is determined by measuring the resistance between two parallel electrodes of a given length spaced apart by the same distance along a surface. Since an increase in the length of the electrodes tends to decrease the resistance observed by an amount equal to that by which the resistance would be increased by lengthening the spacing between the electrode by a like increment, it is apparent that the electrode length and spacing are not material so long as they are identical. Hence, the surface resistivity expressed in ohms per square is a resistance measurement taken for the special case in which electrode length and spacing are identical and therefore mutually cancelling parameters.

In a preferred form, the insulative support 10 is formed of a flexible, electrically insulative plastic sheet, preferably of sufficient toughness that the circuit material prepared therefrom can be handled without injury. Flexible plastic sheets having a thickness from about 10 to about 500 micrometers in thickness are preferred, with those having a thickness of from about 25 to 125 micrometers being particularly preferred for most applications. Particularly preferred are those plastic sheets that exhibit a high degree of dimensional stability, high resistance to thermal degradation, high tensile strength, high dielectric strength, and chemical inertness. In particular, the sheet should exhibit sufficiently high thermal stability to withstand soldering and other high temperature circuit fabrication processes. The dielectric strength of the sheet should be sufficiently high to prevent electrical interference between itself and other circuit elements when several printed circuits are stacked together as in a multilayer printed circuit board. A typical polymeric film suitable in the practice of this invention can have a dielectric constant of from about 3.5 to about 4.5 at 1 KHz, a dissipation factor of from about 0.003 to about 0.005, a dielectric strength of from about 3000 to about 5000 volt/mil, tensile stength of from about 2500 to about 3500 psi, and elongation of from about 45% and about 55%.

A specifically preferred support 10 is a polyimide sheet having a thickness of from about 25 to about 125 micrometers. This sheet is thin, flexible, comparatively dimensionally stable, and capable of producing dry photoresist articles according to this invention which can be readily handled without injury. Other dimensionally and thermally stable polymers have been considered, but have not found widespread use in the industry. Such polymers include polysulfone, polybenzimidazole, polybenzoxazole, and polybenzothiazole.

In order to provide the improved construction for this invention, it is necessary that the plating layer 14 strongly adhere to the support 10. It has been found that the adhesion of the plating layer is improved to a sufficient level by first depositing an adhesion layer 12 of conductive metal having a thickness of about 25 to about 150 Angstroms. Materials that are acceptable for this adhesion layer 12 have two important requirements: (1) they must be capable of forming an effective bond between the support 10 and metal plating layer 14, and (2) they must be capable of resisting typical cleaning chemicals used to prepare the plating layer 14 for electrodeposition. Specifically, the adhesion layer 12 is preferably resistant to the chemicals designed to remove copper oxides, and is also preferably etchable in etchants for copper such as ferric chloride or cupric chloride. It has been discovered that a layer of an alloy of chromium and chromium oxide, as described in U.S. Patent 3,981,961, and incorporated herein by reference, has these preferred properties. In U.S. Patent 3,981,691, the chromium/chromium oxide alloy is referred to as "black-chromium". This alloy is an electrodeposited layer that is based on chromium but which contains a significant percentage of oxygen atoms (often accounting, for example, for 25 weight-percent of the layer, and probably being present as metal oxide molecules) such that the layer will have, in varying shades, a black appearance. Generally, at least a majority of the metal atoms in the layer are chromium atoms.

The plating layer 14 can be any single layer or any combination of layers having an aggregate thickness of less than 10,000 Angstroms and, for maximum savings of material of less than 5,000 Angstroms, and being capable of forming a firm, adherent bond to a metal layer 18, i.e., the plated layer, to be deposited thereon during a subsequent processing step, e.g., electroplating or by electroless desposition. The plating layer 14 should also be capable of being removed with an etchant.

When the plated layer 18 is to be formed by electroplating, the plating layer 14 must be sufficiently electrically conductive to act as a cathode; accordingly it is preferably formed of a metal.

When the plated layer 18 is to be formed by electroless deposition, the plating layer 14 can be formed of any material known to catalyze deposition of the plated metal. For example, when the plating layer 14 is formed of copper, it will catalyze the electroless deposition of copper to form the plated layer 18. Other materials known to catalyze deposition of metal can be used.

The plating layer 14 can be conveniently formed by known techniques for forming thin metal layers, such as, for example, electroless deposition, sputtering, or, preferably, vacuum vapor deposition. Any etchable metal known to be capable of deposition as a thin layer can be used, with metals such as copper, silver, manganese, iron, cobalt, nickel, and zinc being particularly preferred. The most preferred material for the plating layer 14 is copper. When vacuum vapor deposition is employed, two metals can be advantageously deposited from separate sources in a single plating operation, most preferably with some concurrent deposition occurring to insure intimate bonding.

It is preferred that the materials used for the plating layer 14 be etchable in commonly used etchants such as, for example, ferric chloride, cupric chloride, etc. It is also preferred that part of the plating layer 14 be capable of being properly cleaned and prepared for electroplating without being etched away by solutions designed for cleaning, because in order to form a good adhesive bond between the plating layer 14 and the plated layer 18, it is necessary that oxides, e.g., copper oxide, be removed from the surface of the plating layer 14 prior to electroplating. An adhesion layer 12 formed of the alloy of chromium and chromium oxide will not be rapidly etched in conventional preplate cleaning solutions, and electrical conductivity will be maintained, even if the oxide cleaning process were to inadvertantly remove all of the plating layer 14.

Each plated layer 18 formed by deposition onto an exposed surface of the plating layer can be formed of one or more metal layers. The plated layers 18 preferably comprise electrically conductive metals that are tenaciously adherent to the plating layer 14 and to the underlying insulative support. For most applications, the metals for the plated layers are preferably selected from copper, silver, gold, nickel, or other metals known to have excellent electrical conductivity properties. In many instances, at least a portion of the plated layer 18 is chosen so as to permit attachment of other electrical conductors thereto. For example, the plated layer 18 can include a solder overcoat or a noble metal surface coating to reduce oxidation prior to soldering thereto. It is preferred to form the plated layers 18 of metals that can be readily electrolessly deposited or electroplated, such as copper and nickel.

The photoresist layer 16 can be formed of any photoresist composition known to have clean developing characteristics, that is, any composition which is capable of development in a substantially micro-residue free manner. Preferably, the photoresist compositions should be capable of being substantially completely removed from a metal surface without resulting in etching or otherwise damaging the metal surface. Preferably, the photoresist layer 16 is readily removable with mild aqueous developers, such as an aqueous solution of an alkali metal carbonate, silicate, phosphate or the like, or a dilute (0.1 N or less) alkali metal hydroxide, without disturbing a metal layer lying therebeneath. In this way the photoresist layer 16 can be developed without disturbing the thin plating layer 14, which can be readily destroyed with etchants conventionally used for cleaning metal surfaces prior to plating a metal thereon.

A preferred photoresist composition for forming layer 16 is the positive-acting photoresist composition described in U.S. Patent 4,247,616, incorporated herein by reference. This composition comprises (a) a crosslinked urethane resin formed by a catalyzed crosslinking of a non-heat reactive novalac phenolic resin and a diisocyanate compound; (b) an epoxy resin having an epoxide equivalent weight of less than about 400 and a curing agent therefor; and (c) a positive-acting photosensitizer. Other photoresist compositions can be used, but positive-acting compositions are preferred for the reasons stated previously.

The invention will now be more specifically described with the aid of the following non-limiting examples, wherein all parts and percentages are parts and percentages by weight, unless otherwise specified.

## Example 1

A chromium/chromium oxide alloy layer having a thickness of 100 Angstroms was applied to a sheet of polyimide film having a thickness of 100 micrometers by means of RF sputtering at 2.2 KW using a chromium target in an atmosphere of 95% argon and 5% oxygen at a pressure of 5 micrometers. A layer of copper having a thickness of 1000 Angstroms was applied over the chromium/chromium oxide alloy layer, also by means of DC sputtering at 600 volts and 14 amps using a copper target in an atmosphere of argon at a pressure of 1 micrometer. A photoresist layer was then applied over the copper layer. This was accomplished by preparing a coating composition of positive-acting photoresist such as that described in Example 1 of U.S. Patent 4,247,616, incorporated herein by reference. The photoresist coating composition was applied over the copper layer by means of a #10 wire-wound rod and was dried in an oven at 100°C for 1 1/2 minutes. The thickness of the resulting photoresist layer was 0.5 mil (See Fig. 1).

The photoresist layer was then exposed through a patterned film mask, with an ultraviolet light source having wave length of 360 to 440 nm. Development of the image was carried out by using a 1.2% aqueous solution of sodium hydroxide (See Fig. 2).

The exposed copper surface was prepared for electroplating by immersion of the article in a 3% aqueous solution of ammonium persulfate. The cleaned copper surface was then electroplated in a copper sulfate bath operated at room temperature (25°C) at 25 amps/sq. ft. (See Fig. 3).

The remaining portions of the photoresist layer were removed by washing with a 5% aqueous sodium hydroxide solution at 60°C (See Fig. 4).

Finally, the copper layer between the electroformed circuit elements was etched away by immersing the article in a 4% aqueous ferric chloride solution at room temperature (25°C) for 30 seconds (See Fig. 5). Line definition (resolution) and adhesion were excellent.

## Example 2

A nickel layer having a thickness of 100 Angstroms was applied to a sheet of polyimide film having a thickness of 100 micrometers by means of sputtering. A layer of copper having a thickness of 1500 Angstroms was applied over the nickel layer, also by means of sputtering. The photoresist layer was prepared, applied, exposed, and processed in the same manner as in Example 1. The line definition was excellent, but adhesion of the circuit elements was inferior to that demonstrated by the article of Example 1.

Various modifications and alternations of this invention will become apparent to those skilled in the art without departing from the scope and spirit of this invention, and it should be understood that this invention is not to be unduly limited to the following illustrative embodiments set forth herein.

## Claims

1. An article of manufacture comprising:
   a) an electrically insulative support,
   b) an adhesion layer of electrically conductive material adhered to said support, said adhesion layer being an alloy of chromium and chromium oxide,
   c) a plating layer overlying and adhered to said adhesion layer, and
   d) a radiation-sensitive layer overlying said plating layer and adhered to the surface of said plating layer opposed to said adhesion layer.

2. The article of claim 1 wherein said electrically insulative support comprises a polyimide.

3. The article of claim 1 wherein said support has a thickness ranging from about 10 to about 500 micrometers.

4. The article of claim 1 wherein said adhesion layer has a thickness ranging from about 25 to about 150 Angstroms.

5. The article of claim 1 wherein said alloy is black-chromium.

6. The article of claim 1 wherein said plating layer is a conductive metal layer.

7. The article of claim 6 wherein said plating layer is comprised of copper.

8. The article of claim 6 wherein said plating layer is comprised of nickel.

9. The article of claim 1 wherein said plating layer has a thickness of less than 10,000 Angstroms.

10. The article of claim 1 wherein said radiation-sensitive layer is a positive-acting photoresist.

FIG.1

FIG.2

FIG.3

FIG.4

FIG.5